# EUROPÄISCHE PATENTSCHRIFT

(11) **EP 1 768 258 B1**
(45) Veröffentlichungstag und Bekanntmachung des Hinweises auf die Patenterteilung: **31.03.2010**
(21) Anmeldenummer: 06019945.2
(22) Anmeldetag: 23.09.2006
(51) Int. Cl.: H03K 17/95, H03K 17/96, F24C 7/08

(54) **Schaltungsanordnung zur Auswertung eines Sensorzustands**
Circuit for evaluating the state of a sensor
Circuit d'évaluation de l'êtat d'un capteur

(30) Priorität: 26.09.2005 DE 10547186
(43) Veröffentlichungstag der Anmeldung: 28.03.2007
(73) Patentinhaber: E.G.O. ELEKTRO-GERÄTEBAU GmbH, 75038 Oberderdingen (DE)
(72) Erfinder: Jungbauer, Markus, 76646 Bruchsal-Obergrombach (DE); Knappe, Gerd, 75015 Bretten (DE)
(74) Vertreter: Patentanwälte Ruff, Wilhelm, Beier, Dauster & Partner

(56) Entgegenhaltungen:
- EP-A- 0 751 403
- EP-A- 0 788 293
- EP-A- 1 580 487
- DE-A1- 10 042 775
- DE-C1- 3 733 108

## Beschreibung

Die Erfindung betrifft eine Schaltungsanordnung zur Auswertung eines Zustands eines Sensors mit einer induktiven und einer kapazitiven Komponente, der zur Erkennung eines in einer Heizzone eines Kochgerätes aufgestellten Kochgefäßes und zur Berührungserkennung des Kochgefäßes dient. Die Topferkennung kann beispielsweise dazu dienen, eine für eine Heizzone durch einen Benutzer eingestellte Heizleistung erst dann freizugeben bzw. zu erzeugen, wenn sich auch ein Kochgefäß in der Heizzone befindet. Die Berührungserkennung kann beispielsweise zur Auswahl einer Heizzone dienen, für die eine Bedienereinstellung erfolgen soll.

In der nicht vorveröffentlichen deutschen Patentanmeldung DE 10 2004 011 749 der Anmelderin ist ein Sensor zur Erkennung eines in einer Heizzone eines Kochgerätes aufgestellten Kochgefäßes offenbart, der gleichzeitig auch zur Berührungserkennung des Kochgefäßes dienen kann. D.h. durch Auswertung des Sensorzustands kann einerseits ermittelt werden, ob sich auf einer dem Sensor zugeordneten Kochfläche bzw. Heizzone ein Kochgefäß, beispielsweise ein Topf, befindet und andererseits, falls ein Topf vorhanden ist, gleichzeitig eine Berührung des Topfs detektiert werden.

Das Dokument EP 0 751 403 A1 offenbart einen Sensor mit einer kapazitiven und einer induktiven Komponente, wobei eine Betriebszustandssteuereinheit in einer ersten Betriebsart einen LC-Schwingkreis aus einem Kondensator und dem Sensor und in einer zweiten Betriebsart einen den Sensor enthaltenden RC-Oszillator bildet.

### Aufgabe und Lösung

Der Erfindung liegt die Aufgabe zugrunde, eine Schaltungsanordnung zur Auswertung eines Sensors der eingangs genannten Art zur Verfügung zu stellen, die eine zuverlässige und kostengünstige Auswertung eines Sensorzustands gewährleistet, d.h. mit der eine zuverlässige Topf- und Berührungserkennung durchgeführt werden kann.

Die Erfindung löst diese Aufgabe durch eine Schaltungsanordnung nach Anspruch 1. Vorteilhafte sowie bevorzugte Ausgestaltungen der Erfindung sind Gegenstand der weiteren Ansprüche und werden im folgenden näher erläutert. Der Wortlaut der Ansprüche wird dabei durch ausdrückliche Bezugnahme zum Inhalt der Beschreibung gemacht.

Erfindungsgemäß ist eine Spule, ein Kondensator und eine Betriebszustandssteuereinheit vorgesehen. Eine Spule im Sinne der Erfindung ist definitionsgemäß ein im wesentlichen induktives Bauelement und ein Kondensator ein im wesentlichen kapazitives Bauelement. Die Betriebszustandssteuereinheit ist derart eingerichtet, dass sie in einer Betriebsart zur Topferkennung einen ersten Schwingkreis aus dem Kondensator und dem Sensor und in einer Betriebsart zur Berührungserkennung einen zweiten Schwingkreis aus der Spule und dem Sensor bildet. Hierbei wird von der Eigenschaft des Sensors gebrauch gemacht, dass sich dessen wirksame Induktivität in Abhängigkeit davon ändert, ob sich ein Topf im Bereich des Sensors befindet oder nicht, und dass sich dessen wirksame Kapazität in Abhängigkeit von einer Berührung eines Kochgefäßes verändert. Bei der Topferkennung wird folglich die Induktivität bzw. die Induktivitätsänderung und bei der Berührungserkennung die Kapazität bzw. die Kapazitätsänderung des Sensors ausgewertet. Zur Bestimmung der Induktivität bzw. der Induktivitätsänderung, d.h. zur Topferkennung, wird ein erster LC-Schwingkreis aus dem Sensor bzw. seinem induktiven Anteil und dem Kondensator gebildet. Eine sich einstellende Schwingkreisfrequenz, die wesentlich vom wirksamen Induktivitätswert des Sensors abhängt, wird zur Auswertung des Sensorzustands verwendet. Zur Bestimmung der Kapazität bzw. der Kapazitätsänderung, d.h. zur Berührungserkennung, wird ein zweiter LC-Schwingkreis aus dem Sensor bzw. seinem kapazitiven Anteil und der Spule gebildet. Eine sich einstellende Schwingkreisfrequenz, die wesentlich vom wirksamen Kapazitätswert des Sensors abhängt, wird zur Auswertung des Sensorzustands verwendet.

In einer Weiterbildung sind die Spule und der Kondensator jeweils zwischen einen ersten Anschluss des Sensors und ein Massepotential und/oder Erdpotential eingeschleift. Dies erleichtert die Bestimmung von Streukapazitätsänderungen, die von einer Berührung des Kochgefäßes bewirkt werden.

In einer Weiterbildung ist ein durch die Betriebszustandssteuereinheit ansteuerbares erstes Schaltmittel zwischen einen ersten Anschluss des Sensors und die Spule eingeschleift. Durch Öffnen des Schaltmittels kann die Spule in der Betriebsart zur Topferkennung vom Schwingkreis getrennt werden, wodurch sich Induktivitätsänderungen des Sensors stärker auf die Schwingkreisfrequenz auswirken. Dies erleichtert die Topferkennung.

In einer Weiterbildung ist ein durch die Betriebszustandssteuereinheit ansteuerbares zweites Schaltmittel zwischen einen ersten Anschluss des Sensors und den Kondensator eingeschleift. Durch Öffnen des Schaltmittels kann der Kondensator in der Betriebsart zur Berührungserkennung vom Schwingkreis getrennt werden, wodurch sich Kapazitätsänderungen des Sensors stärker auf die Schwingkreisfrequenz auswirken. Dies erleichtert die Berührungserkennung.

In einer Weiterbildung ist ein durch die Betriebszustandssteuereinheit ansteuerbares drittes Schaltmittel zwischen einen zweiten Anschluss des Sensors und ein Massepotential und/oder Erdpotential eingeschleift. Dies ermöglicht ein betriebszustandsabhängiges Auftrennen einer Masseverbindung des Sensors. In der Betriebsart zur Topferkennung ist das dritte Schaltmittel geschlossen, wodurch der Sensor im wesentlichen als Induktivität wirkt, d.h. er wird als induktiver Sensor betrieben. In der Betriebsart zur Berührungserkennung ist das dritte Schaltmittel geöffnet, wodurch der Sensor im wesentlichen über seine Streukapazität gegen Masse bzw. Erde wirkt, d.h. er wird als kapazitiver Sensor betrieben. Die Streukapazität des Sensors verändert sich hierbei in Abhängigkeit von einer Berührung eines gegebenenfalls vorhandenen Gefäßes.

In einer Weiterbildung ist der Kondensator mit einem zweiten Anschluss des Sensors verbunden. Der Kondensator kann parallel zum Sensor geschaltet sein.

In einer Weiterbildung ist eine Entdämpfungseinheit zur Kompensation von Dämpfungsverlusten des ersten und/oder des zweiten Schwingkreises vorgesehen. Dies erleichtert die Auswertung der Resonanzfrequenz der jeweiligen Schwingkreise, da eine Schwingungsamplitude durch die Entdämpfungseinheit in etwa konstant gehalten wird.

In einer Weiterbildung ist der Sensor eine ein- oder mehrwindige Spule, die im Heizbereich eines Strahlungsheizkörpers angeordnet ist. Eine solche Spule ist beispielsweise aus der EP 788 293 A bekannt.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher beschrieben. Hierbei zeigen:
- Fig. 1: ein Blockschaltbild einer ersten Ausführungsform einer Schaltungsanordnung zur Auswertung eines Zustands mehrerer Sensoren zur Topf- und Berührungserkennung,
- Fig. 2: ein Schaltbild eines Kreises des in Fig. 1 gezeigten Blockschaltbildes und
- Fig. 3: ein Schaltbild einer weiteren Ausführungsform einer Schaltungsanordnung zur Auswertung eines Zustands mehrerer Sensoren zur Topf- und Berührungserkennung.

### Detaillierte Beschreibung der Ausführungsbeispiele

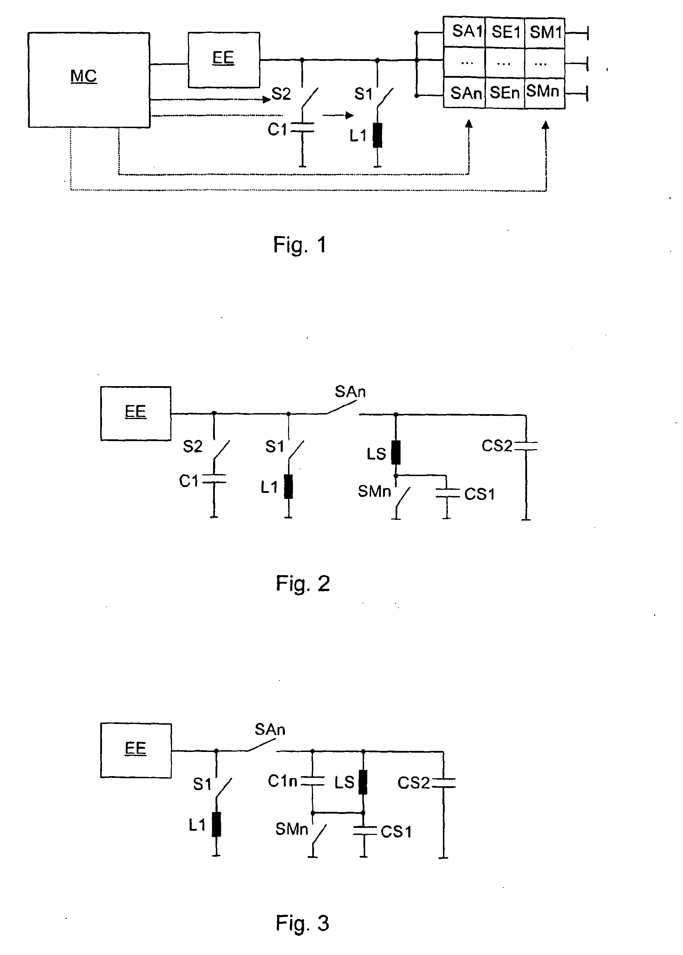

Fig. 1 zeigt ein Blockschaltbild einer ersten Ausführungsform einer Schaltungsanordnung zur Auswertung eines Zustands mehrerer Sensoren SE1 bis SEn zur Topf- und Berührungserkennung. Die Sensoren SE1 bis SEn können beispielsweise jeweils einer zugehörigen Kochstelle eines Herdes zugeordnet sein. Die Schaltungsanordnung umfasst einen Kondensator C1, eine Spule L1, die Sensoren SE1 bis SEn, die jeweils induktive und kapazitive Komponenten aufweisen, eine Entdämpfungseinheit EE, eine Betriebszustandssteuereinheit in Form eines Mikrocontrollers MC, Schaltmittel S1 und S2. Auswahlschaltmittel, SA1 bis SAn und Erdungsschaltmittel SM1 bis SMn. Die Sensoren SE1 bis SEn sind Spulen, wie sie vorstehend beschrieben worden sind, an einem nicht gezeigten Strahlungsheizkörper einer Heizzone eines Kochgerätes.

Erste Anschlüsse der Auswahlschaltmittel SA1 bis SAn, ein Ausgangsanschluss der Entdämpfungseinheit EE und jeweils erste Anschlüsse der Schaltmittel S1 und S2 sind miteinander verbunden. Die Spule L1 und der Kondensator C1 sind zwischen einen jeweils ersten Anschluss der Sensoren SE1 bis SEn und ein Massepotential bzw. Erdpotential eingeschleift, wobei zwischen die Spule L1 und die jeweiligen ersten Anschlüsse der Sensoren SE1 bis SEn das Schaltmittel S1 und ein zugehöriges Auswahlschaltmittel SA1 bis SAn eingeschleift ist und zwischen den Kondensator C1 und die jeweiligen ersten Anschlüsse der Sensoren SE1 bis SEn das Schaltmittel S2 und ein zugehöriges Auswahlschaltmittel SA1 bis SAn eingeschleift ist. Die Erdungsschaltmittel SM1 bis SMn sind zwischen einen jeweils zweiten Anschluss eines zugehörigen Sensors SE1 bis SEn und das Massepotential bzw. Erdpotential eingeschleift.

Die Schaltmittel S1, S2, SA1 bis SAn und SM1 bis SMn werden betriebszustandsabhängig von der Betriebszustandssteuereinheit MC angesteuert. Sie können als elektromechanische oder elektronische Schalter, beispielsweise Relais oder Transistoren, insbesondere MOS-Feldeffekttransistoren, ausgeführt sein.

Die Auswahlschaltmittel SA1 bis SAn dienen zur Auswahl eines Sensorkreises bzw. eines einer Kochstelle zugeordneten Sensors SE1 bis SEn, wobei zur Auswahl einer Kochstelle der zugehörige Schalter geschlossen wird und die Schalter der nicht ausgewählten Kochstellen bzw. Sensoren geöffnet sind bzw. geöffnet werden.

Fig. 2 zeigt ein Schaltbild eines Kreises n des in Fig. 1 gezeigten Blockschaltbildes. Der Sensor SEn von Fig. 1 weist eine induktive Komponente LS und kapazitive Komponenten CS1 und CS2 auf. Die kapazitive Komponente CS1 wirkt zwischen dem zweiten Anschluss des Sensors SEn und Masse bzw. Erde und die kapazitive Komponente CS2 wirkt zwischen dem ersten Anschluss des Sensors SEn und Masse bzw. Erde. Die kapazitiven Komponenten CS1 und CS2 sind keine realen diskreten Bauelemente, sondern bilden im wesentlichen die konzentrierten Streukapazitäten des Sensors SEn gegen Masse bzw. Erde ab. Die gesamte Streukapazität des im wesentlichen induktiven Sensors SEn gegen einen geerdeten Bezugskörper, beispielsweise ein Halteblech eines Strahlungsheizkörpers, ergibt sich aus der Summe der beiden Schaltbildkomponenten CS1 und CS2.

In einer Betriebsart zur Topferkennung wird im wesentlichen die induktive Komponente LS des Sensors SEn ausgewertet, da sich diese in Abhängigkeit davon ändert, ob sich ein metallischer Gegenstand, beispielsweise ein Topf, im Bereich des Sensors SEn befindet oder nicht. Zur Auswertung wird daher durch die Betriebszustandssteuereinheit MC der Schalter S1 geöffnet und die Schalter S2 und SMn geschlossen. Während einer aktiven Auswertung des Sensors SEn bleibt der Auswahlschalter SAn unabhängig davon geschlossen, ob eine Topf- oder eine Berührungserkennung durchgeführt wird.

In der Betriebsart zur Topferkennung wird somit ein erster LC-Parallelschwingkreis im wesentlichen aus dem Kondensator C1 und dem Sensor in Form seiner induktiven Komponente LS gebildet. Die kapazitiven Komponenten CS1 und CS2 sind in dieser Betriebsart vernachlässigbar. Eine sich einstellende Schwingkreisfrequenz, die wesentlich vom wirksamen Induktivitätswert der induktiven Komponente LS abhängt, wird zur Auswertung des Sensorzustands bzw. zur Topferkennung verwendet. Der Sensor SEn wird folglich in dieser Betriebsart im wesentlichen als induktiver Sensor betrieben. Die Entdämpfungseinheit EE dient zur Kompensation von Dämpfungsverlusten des Schwingkreises.

In einer Betriebsart zur Berührungserkennung werden im wesentlichen die kapazitiven Komponenten bzw. die Streukapazitäten CS1 und CS2 des Sensors SEn ausgewertet, da sich diese in Abhängigkeit davon ändern, ob beispielsweise ein Topf, der sich Bereich des Sensors SEn befindet, berührt wird oder nicht. Zur Auswertung wird daher durch die Betriebszustandssteuereinheit MC der Schalter S1 geschlossen und die Schalter S2 und SMn geöffnet.

In der Betriebsart zur Berührungserkennung wird somit ein zweiter LC-Parallelschwingkreis im wesentlichen aus der Spule L1 und dem Sensor in Form seiner kapazitiven Komponenten CS1 und CS2 gebildet. Der zuvor induktiv wirkende Sensor wird somit insbesondere durch Öffnen des Schalters SMn als kapazitiver Sensor betrieben. Hierbei bilden die Sensorspule LS die erste Elektrode und beispielsweise das geerdete Halteblech des Strahlungsheizkörpers die zweite Elektrode des kapazitiven Sensors. Da sich die Streukapazitäten CS1 und CS2 bei geöffnetem Schalter SMn durch eine Handkapazität bzw. durch die Kapazität eines Berührenden berührungsabhängig verändern bzw. die Handkapazität parallel zur Streukapazität CS2 wirkt, verändert sich die Schwingkreisfrequenz des Parallelschwingkreises deutlich. Die sich einstellende Schwingkreisfrequenz des Parallelschwingkreises wird zur Auswertung des Sensorzustands bzw. zur Berührungserkennung verwendet. Aufgrund des geöffneten Schalters S2 wird der Kondensator C1 deaktiviert.

Fig. 3 zeigt ein Schaltbild einer weiteren Ausführungsform einer Schaltungsanordnung zur Auswertung des Zustands der Sensoren SE1 bis SEn zur Topf- und Berührungserkennung für einen Kreis n. Funktionsgleiche Schaltkreiskomponenten sind mit identischen Bezugszeichen versehen. Hinsichtlich ihrer Funktion wird auf die obige Beschreibung verwiesen.

Die in Fig. 3 gezeigte Variante benötigt im Vergleich zu der in Fig. 2 gezeigten Variante lediglich drei anstatt vier Schaltmittel zur Betriebszustandsumschaltung. Die in Fig. 3 gezeigte Variante erfordert jedoch pro Kreis einen Kondensator C1n, welcher einem jeweiligen Sensor SEn parallel geschaltet ist, wohingegen die in Fig. 1 gezeigte Variante lediglich einen Kondensator C1 erfordert.

In einer Betriebsart zur Topferkennung wird der Schalter S1 geöffnet und der Schalter SMn geschlossen. Bei ausgewähltem Kreis n ist der Schalter SAn geschlossen. Es bildet sich folglich ein Parallelschwingkreis aus dem Kondensator C1n und dem kapazitiven Anteil bzw. der Streukapazität CS2 und dem induktiven Anteil LS des Sensors SEn. Da ein Kapazitätswert des Kondensators C1n wesentlich größer als die Streukapazität CS2 ist, kann diese vernachlässigt werden.

Eine sich einstellende Schwingkreisfrequenz, die im wesentlichen vom wirksamen Induktivitätswert der induktiven Komponente LS abhängt, wird zur Auswertung des Sensorzustands bzw. zur Topferkennung verwendet. Der Sensor SEn wird folglich in dieser Betriebsart im wesentlichen als induktiver Sensor betrieben.

In einer Betriebsart zur Berührungserkennung wird der Schalter S1 geschlossen und der Schalter SMn geöffnet. Es bildet sich folglich ein Parallelschwingkreis aus der Spule L1, dem kapazitiven Anteil bzw. der Streukapazität CS2 und einer Parallelschaltung des Kondensators C1n und des induktiven Anteils LS in Serie mit dem kapazitiven Anteil CS1. Die Reihen- bzw. Serienschaltung des Kondensators C1n und der Streukapazität CS1 parallel zur Streukapazität CS2 bilden den Kapazitätswert des Parallelschwingkreises. Eine zusätzliche Handkapazität durch Berühren des Topfes, parallel zur Streukapazität CS2 führt zu einer Frequenzänderung der Schwingkreisfrequenz. Eine sich einstellende Schwingkreisfrequenz kann daher zur Auswertung des Sensorzustands bzw. zur Berührungserkennung verwendet werden. Der Sensor SEn wird folglich in dieser Betriebsart im wesentlichen als kapazitiver Sensor betrieben.

Den gezeigten Ausführungsformen ist gemeinsam, dass zur Berührungserkennung der Sensor, üblicherweise eine mehrwindige Spule mit im wesentlichen induktiven Anteilen, als kapazitiver Sensor betrieben wird. Die berührungsabhängige Streukapazitätsänderung des Sensors wird dadurch ausgewertet, dass der Sensor von seinem Masse- bzw. Erdanschluss getrennt wird. Wenn in diesem Betriebszustand dem Sensor eine Spule parallel geschaltet und der zur Topferkennung verwendete Kondensator deaktiviert bzw. schaltungstechnisch unwirksam beschaltet wird, kann die Streukapazitätsänderung zur Berührungserkennung ausgewertet werden.

Die gezeigten Ausführungsbeispiele ermöglichen die Auswertung nur eines Sensors oder mehrerer Sensoren in einem Multiplexbetrieb. Die beschriebene Sensorsignalauswertungsschaltung ermöglicht eine zuverlässige und kostengünstige Auswertung eines Sensorzustands zur gleichzeitigen Topf- und Berührungserkennung, wobei hierfür keine getrennten Schaltungsanordnungen vorzusehen sind.

## Patentansprüche

1. Schaltungsanordnung zur Auswertung eines Zustands mindestens eines Sensors (SE1 bis SEn) mit einer induktiven und einer kapazitiven Komponente (LS, CS1, CS2), der zur Erkennung eines in einer Heizzone eines Kochgerätes aufgestellten Kochgefäßes und zur Berührungserkennung des Kochgefäßes dient, mit
- einer Spule (L1),
- einem Kondensator (C1, C1n) und
- einer Betriebszustandssteuereinheit (MC), die derart eingerichtet ist, dass sie in einer Betriebsart zur Topferkennung einen ersten LC-Schwingkreis aus dem Kondensator (C1,C1n) und dem Sensor (SE1 bis SEn) und in einer Betriebsart zur Berührungserkennung einen zweiten LC-Schwingkreis aus der Spule (L1) und dem Sensor (SE1 bis SEn) bildet.

2. Schaltungsanordnung nach Anspruch 1, **dadurch gekennzeichnet, dass** die Spule (L1) und der Kondensator (C1, C1n) jeweils zwischen einen ersten Anschluss des Sensors und ein Massepotential und/oder Erdpotential eingeschleift sind.

3. Schaltungsanordnung nach Anspruch 1 oder 2, **gekennzeichnet durch** ein **durch** die Betriebszustandssteuereinheit (MC) ansteuerbares erstes Schaltmittel (S1), das zwischen einen ersten Anschluss des Sensors (SE1 bis SEn) und die Spule (L1) eingeschleift ist.

4. Schaltungsanordnung nach einem der vorhergehenden Ansprüche, **gekennzeichnet durch** ein **durch** die Betriebszustandssteuereinheit (MC) ansteuerbares zweites Schaltmittel (S2), das zwischen einen ersten Anschluss des Sensors (SE1 bis Sen) und den Kondensator (C1) eingeschleift ist.

5. Schaltungsanordnung nach einem der vorhergehenden Ansprüche, **gekennzeichnet durch** ein **durch** die Betriebszustandssteuereinheit (MC) ansteuerbares drittes Schaltmittel (SM1 bis SMn), das zwischen einen zweiten Anschluss des Sensors (SE1 bis SEn) und ein Massepotential und/oder Erdpotential eingeschleift ist.

6. Schaltungsanordnung nach einem der vorhergehenden Ansprüche, **dadurch gekennzeichnet, dass** der Kondensator (C1n) mit einem zweiten Anschluss des Sensors (SE1 bis SEn) verbunden ist.

7. Schaltungsanordnung nach einem der vorhergehenden Ansprüche, **gekennzeichnet durch** eine Entdämpfungseinheit (EE) zur Kompensation von Dämpfungsverlusten des ersten und/oder des zweiten LC-Schwingkreises.

8. Schaltungsanordnung nach einem der vorhergehenden Ansprüche, **dadurch gekennzeichnet, dass** der Sensor (SE1 bis SEn) eine Spule mit einer oder mehreren Windungen ist, die in der Heizzone eines Strahlungsheizkörpers angeordnet ist.

## Claims

1. A circuit for evaluating a state of at least one sensor (SE1 through SEn) having an inductive and a capacitive component (LS, CS1, CS2) for detecting a cooking vessel placed in a heating zone of a cooking device and for touch detection of said cooking vessel, comprising
- a coil (L1),
- a capacitor (C1, C1n), and
- an operational state control unit (MC) arranged to provide a first LC-oscillator including said capacitor (C1, C1n) and said sensor (SE1 through SEn) in an operation mode for vessel detection and a second LC-oscillator including said coil (L1) and said sensor (SE1 through SEn) in an operation mode for touch detection.

2. The circuit according to claim 1, **characterized in that** said coil (L1) and said capacitor (C1, C1n) each are connected between a first connection of said sensor and a earth potential and/or a ground potential.

3. The circuit according to claim 1 or 2, **characterized by** a first switching means (S1) that is connected between a first connection of said sensor (SE1 through SEn) and said coil (L1) and controllable by said operational state control unit (MC).

4. The circuit according to any of the preceding claims, **characterized by** a second switching means (S2) that is connected between a first connection of said sensor (SE1 through SEn) and said capacitor (C1) and controllable by said operational state control unit (MC).

5. The circuit according to any of the preceding claims, **characterized by** a third switching means (SM1 through SMn) that is connected between a second connection of said sensor (SE1 through SEn) and a earth potential and/or ground potential and controllable by said operational state control unit (MC).

6. The circuit according to any of the preceding claims, **characterized in that** said capacitor (C1n) is connected to a second connection of said sensor (SE1 through SEn).

7. The circuit according to any of the preceding claims, **characterized by** a deattenuation unit (EE) for compensating attenuation losses of said first and/or said second LC-oscillator.

8. The circuit according to any of the preceding claims, **characterized in that** said sensor (SE1 through SEn) is a coil having one or more windings arranged in the heating zone of a radiation heating device.

## Revendications

1. Arrangement de circuit pour interpréter un état d'au moins un capteur (SE1 à SEn) comprenant un composant inductif et un composant capacitif (LS, CS1, CS2), lequel sert à détecter un récipient de cuisson posé dans une zone de chauffe d'un appareil de cuisson et à détecter le contact avec le récipient de cuisson, comprenant
- une bobine (L1),
- un condensateur (C1, C1n) et
- une unité de contrôle de mode de fonctionnement (MC) qui est configurée de telle sorte que dans un mode de détection de casserole, elle forme un premier circuit oscillant LC composé du condensateur (C1, C1n) et du capteur (SE1 à SEn) et dans un mode de détection de contact, elle forme un deuxième circuit oscillant LC composé de la bobine (L1) et du capteur (SE1 à SEn).

2. Arrangement de circuit selon la revendication 1, **caractérisé en ce que** la bobine (L1) et le condensateur (C1, C1n) sont respectivement intercalés entre une première borne du capteur et un potentiel de masse et/ou un potentiel de terre.

3. Arrangement de circuit selon la revendication 1 ou 2, **caractérisé par** un premier moyen de commutation (S1) qui peut être commandé par l'unité de contrôle de mode de fonctionnement (MC) et qui est intercalé entre une première borne du capteur (SE1 à SEn) et la bobine (L1).

4. Arrangement de circuit selon l'une des revendications précédentes, **caractérisé par** un deuxième moyen de commutation (S2) qui peut être commandé par l'unité de contrôle de mode de fonctionnement (MC) et qui est intercalé entre une première borne du capteur (SE1 à SEn) et le condensateur (C1).

5. Arrangement de circuit selon l'une des revendications précédentes, **caractérisé par** un troisième moyen de commutation (SM1 à SMn) qui peut être commandé par l'unité de contrôle de mode de fonctionnement (MC) et qui est intercalé entre une deuxième borne du capteur (SE1 à SEn) et un potentiel de masse et/ou un potentiel de terre.

6. Arrangement de circuit selon l'une des revendications précédentes, **caractérisé en ce que** le condensateur (C1n) est relié avec une deuxième borne du capteur (SE1 à SEn).

7. Arrangement de circuit selon l'une des revendications précédentes, **caractérisé par** une unité de compensation d'amortisseur (EE) destinée à compenser les pertes d'amortissement du premier et/ou du deuxième circuit oscillant LC.

8. Arrangement de circuit selon l'une des revendications précédentes, **caractérisé en ce que** le capteur (SE1 à SEn) est une bobine comprenant une ou plusieurs spires, disposée dans la zone chauffante d'un corps chauffant rayonnant.
